Europäisches Patentamt

European Patent Office

Office européen des brevets

(11) Numéro de publication: **0 198 549**
**A2**

## (12) DEMANDE DE BREVET EUROPEEN

(21) Numéro de dépôt: **86200610.3**

(22) Date de dépôt: **10.04.86**

(51) Int. Cl.4: **G01J 1/04** , **H01L 31/02** , **H04N 5/335**

(30) Priorité: **12.04.85 FR 8505519**

(43) Date de publication de la demande:
**22.10.86 Bulletin 86/43**

(84) Etats contractants désignés:
**BE DE FR GB IT NL SE**

(71) Demandeur: **TELECOMMUNICATIONS RADIOELECTRIQUES ET TELEPHONIQUES T.R.T.**
**88, rue Brillat Savarin**
**F-75013 Paris(FR)**
Demandeur: **N.V. Philips' Gloeilampenfabrieken**
**Groenewoudseweg 1**
**NL-5621 BA Eindhoven(NL)**

(72) Inventeur: **Fouilloy, Jean-Pierre**
**SOCIETE CIVILE S.P.I.D. 209 rue de l'Université**
**F-75007 Paris(FR)**
Inventeur: **Marche, Pierre**
**SOCIETE CIVILE S.P.I.D. 209 rue de l'Université**
**F-75007 Paris(FR)**

(74) Mandataire: **Chaffraix, Jean et al**
**Société Civile S.P.I.D. 209, rue de l'Université**
**F-75007 Paris(FR)**

(54) **Dispositif de limitation et d'uniformisation du champ de vue de mosaiques de détecteurs IR.**

(57) Dispositif de limitation et d'uniformisation du champ de vue de mosaïques d'éléments détecteurs (4) recevant le flux utile venant de la scène observée. Chacun des éléments détecteurs est fixé sur un support froid (2) à l'intérieur d'une enceinte (6) vide d'air ou remplie d'un gaz à faible conductibilité thermique. Une galette mince de fibres optiques (1), solidaires du support froid et transparentes dans la bande spectrale désirée, est disposée dans l'enceinte au contact ou à faible distance des éléments détecteurs et en regard d'un hublot (5) transparent au moins dans ladite bande spectrale.

Application : détecteurs infra-rouge.

# DISPOSITIF DE LIMITATION ET D'UNIFORMISATION DU CHAMP DE VUE DE MOSAIQUES DE DETECTEURS IR.

L'invention concerne un dispositif convertisseur de rayonnement optique en signaux électroniques, comportant une mosaïque de p rangées de q éléments sensibles au rayonnement occupant une grande surface par rapport aux dimensions d'un élément sensible et fournissant p x q sorties de signal, et un faisceau de fibres optiques refroidies, transparentes dans la bande de sensibilité spectrale désirée et qui transmettent auxdits éléments sensibles le rayonnement utile venant d'une scène observée.

Dans de tels dispositifs il s'impose la nécessité de limiter le champ de vue d'un détecteur, ou élément sensible, lorsque le fond est à une température suffisante pour rayonner dans le spectre de sensibilité du détecteur. Il en résulte un flux parasite qui augmente le bruit ainsi que le signal continu fourni par le détecteur d'une façon dépendante de la température du fond.

Un moyen simple de protection contre ce flux parasite consiste à placer à l'avant du détecteur un écran froid limitant l'angle solide sous lequel le flux est reçu à la valeur utile correspondant au rayonnement émis par la scène.

Dans le cas d'un détecteur comportant de multiples éléments sensibles, l'écran froid limite le champ de vue de chaque détecteur d'une façon différente. L'angle délimité par cet écran dépend de la position de chaque élément sensible par rapport à l'écran froid.

Ceci est particulièrement marqué pour les détecteurs à traitement dans le plan focal, qui comprennent généralement une mosaïque d'éléments répartis sur une surface rectangulaire. Chaque élément sensible occupant par rapport à l'écran froid une place particulière reçoit un flux différent des autres éléments. Une partie de ce flux est le flux utile (généralement la partie centrale venant d'un objectif) l'autre partie est le flux du fond (généralement la partie annulaire venant de la monture de l'objectif).

Cet effet vient s'ajouter aux variations de sensibilité des éléments détecteurs et aux variations de couplage entre ces éléments et les circuits d'exploitation des charges apparaissant sur les détecteurs. Comme le flux venant des montures de l'objectif est fonction de la température de ces montures, cet effet doit être corrigé afin que la réponse de tous les détecteurs au flux continu soit uniforme.

La correction peut être effectuée en recevant les flux considérés ci-dessus sur une extrémité d'un faisceau de fibres optiques dont l'autre extrémité est couplée au détecteur ainsi qu'il est indiqué dans le préambule. Chaque élément sensible du détecteur reçoit ainsi le rayonnement de la scène vers laquelle il est dirigé dans un angle solide égal à l'angle d'acceptance d'une fibre, tandis que le rayonnement parasite en provenance du fond et dont les angles d'attaque sont supérieurs à cet angle d'acceptance est absorbé dans la gaine de la fibre.

Le brevet japonais n° 58-43673 décrit un dispositif de ce genre dans lequel une extrémité d'un faisceau de fibres optiques est mise au contact d'un élément détecteur constitué par un photocapteur à barrière de Schottky. La configuration de ce détecteur dont la face opposée à celle exposée au rayonnement comporte de multiples électrodes pose un problème de refroidissement qui est résolu par l'immersion du détecteur dans de l'azote liquide. Le rôle de la fibre optique est de transférer sur le détecteur, à travers le liquide réfrigérant, le flux incident à l'autre extrémité du faisceau et d'assurer le refroidissement uniforme du détecteur par contact entre le détecteur et la fibre d'une part et entre la fibre et le liquide réfrigérant d'autre part. Le but de ce dispositif n'est donc pas de limiter le champ et il s'applique au cas particulier d'un détecteur à barrière de Schottky éclairé par la face arrière dont le fonctionnement nécessite l'immersion dans un milieu réfrigérant. La traversée de ce milieu impose une grande longueur du faisceau de fibres dont une extrémité est à la température ambiante extérieure et l'autre extrémité est à la température du réfrigérant. Il en résulte une consommation importante de liquide réfrigérant.

Le dispositif de l'invention a pour but d'assurer la limitation et l'uniformité du champ de vue de mosaïques de détecteurs. Il s'applique à toutes sortes de détecteurs pouvant être convenablement refroidis sans qu'une immersion s'avère nécessaire.

Conformément à l'invention ledit dispositif est caractérisé en ce que le faisceau de fibres optiques est constitué par une galette de faible épaisseur solidaire d'un support froid, la mosaïque d'éléments sensible étant fixée par l'une de ses faces sur ledit support froid à l'intérieur d'une enceinte à faible conductibilité thermique, ladite galette étant en regard d'un hublot transparent dans ladite bande spectrale, l'angle solide uniforme sous lequel chaque élément sensible reçoit du rayonnement étant égal à l'angle d'acceptance d'une fibre.

On sait que les fibres optiques ont un angle d'acceptance maximum au-delà duquel les rayons ne subissent plus la réflexion totale entre le coeur et la gaine et se perdent dans celle-ci ou sont absorbés par le matériau liant les différentes fibres pour obtenir une galette. Si $n_0$ est l'indice du milieu ambiant, $n_1$ l'indice du coeur et $n_2$ l'indice de la gaine, l'angle d'acceptance u est donné par la relation : $n_0 \sin u =$

$$\sqrt{(n^2_1 - n^2_2)1/2}.$$

La galette étant refroidie, la contribution énergétique des rayons plus inclinés est négligeable et la galette joue le rôle d'un écran froid définissant le même angle pour tous les éléments détecteurs.

Si la galette de fibres est précédée par un objectif dont la pupille de sortie est à l'infini et dont l'ouverture est plus grande ou égale à celle des fibres, les seuls rayons tombant sur les détecteurs sont issus de la scène dont on veut mesurer le rayonnement.

Ainsi les inconvénients signalés ci-dessus, variation du flux parasite selon l'emplacement de l'élément détecteur, selon la température de la monture, bruit amené par le flux parasite, sont éliminés.

La description suivante en regard des dessins annexés, le tout donné à titre d'exemple, fera bien comprendre comment l'invention peut être réalisée.

La figure 1 montre des configurations d'angles solides de détecteurs disposés dans le plan focal, à une distance z d'un écran froid.

La figure 2 représente la structure d'un dispositif de limitation du champ de vue de mosaïques de détecteurs conforme à l'invention.

La figure 3 représente une première application du dispositif conforme à l'invention, associant une fibre optique à chaque élément sensible du détecteur, celui-ci étant plaqué à la fibre.

La figure 4 représente une seconde application du dispositif conforme à l'invention, associant une fibre optique à chaque élément sensible du détecteur, celui-ci étant à la distance d de la fibre.

La figure 5 montre une troisième application du dispositif conforme à l'invention, associant k fibres optiques à chaque élément sensible du détecteur, plaquées ou non aux éléments.

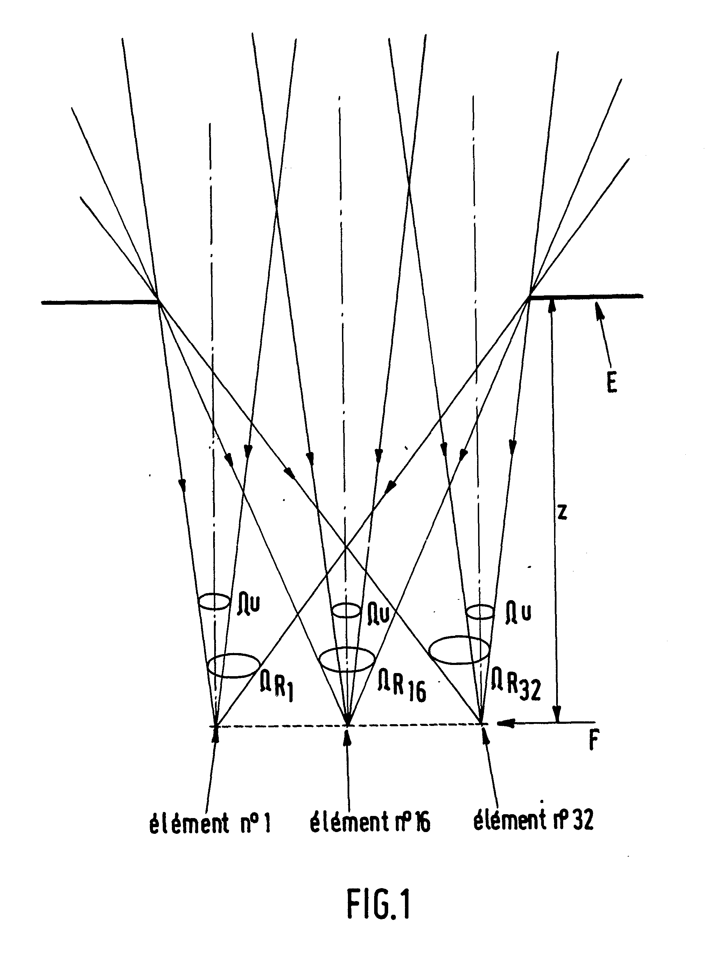

La figure 1 montre l'allure des angles solides réels $\Omega_R$ de certains éléments sensibles d'un détecteur (par exemple les éléments n° 1, 16 et 32), délimités par un écran froid E situé à une distance z du détecteur, ce dernier étant disposé dans le plan focal F. Soient $\Omega_{R1}$, $\Omega_{R16}$ et $\Omega_{R32}$ les angles solides correspondant respectivement à ces éléments. Le champ utile $\Omega_u$ de chacun des éléments a été de même représenté sur cette figure.

On considère par exemple un écran froid situé à 5 mm d'une mosaïque de 32 lignes de 32 éléments détecteurs carrés de 50 $\mu$m de côté espacés de 50 $\mu$m. Cette mosaïque étant placée au foyer d'une optique ouverte à F/4 et dont la pupille est située à l'infini, découpe des angles solides réels variant selon la position des éléments entre 0,49 et 0,62 stéradian, alors que le champ de vue utile vaut 0,05 stéradian.

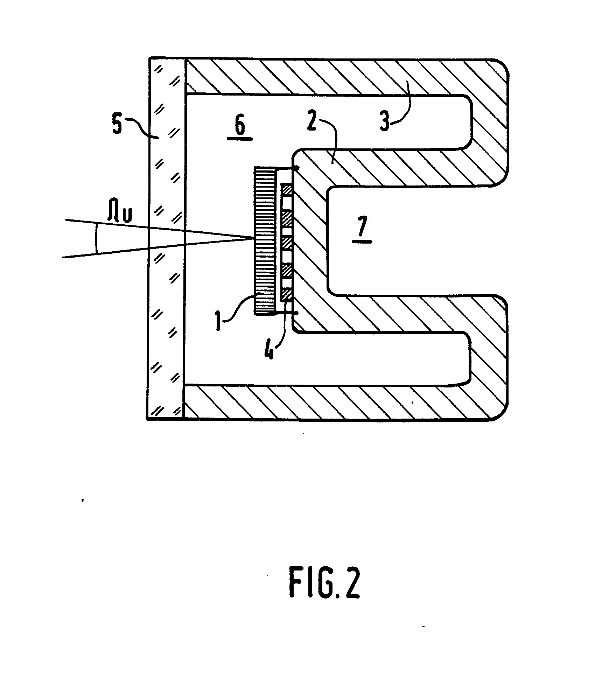

La structure du dispositif de l'invention représentée sur la figure 2 comporte une galette mince de fibres optiques 1 solidaire d'un support froid 2 sur lequel est fixé le détecteur 4 et disposée au contact ou à très petite distance de ce dernier.

Le support froid 2 est partie d'une enveloppe 3 fermée à l'avant par un hublot 5.

La galette de fibres et le hublot sont transparents dans la bande spectrale de transmission désirée qui peut être choisie de façon à adapter la sensibilité spectrale de l'ensemble au problème posé par les conditions d'utilisation. Ainsi la fibre peut jouer le rôle d'un filtre froid, ce qui améliore la sensibilité du détecteur par réduction du flux du fond.

L'espace clos 6 délimité par l'enveloppe 3 et le hublot 5 est vide d'air ou rempli d'un gaz à faible conductibilité thermique.

La partie 2 de l'enveloppe 3 servant de support au détecteur a la forme d'un doigt dont l'intérieur 7 est refroidi par un procédé quelconque : contact intime avec un milieu réfrigérant tel que l'azote liquide, détente de gaz en circuit ouvert, utilisation d'une machine à froid en circuit fermé etc...

Le détecteur disposé dans l'espace clos 6 est constitué par une mosaïque de p rangées de q éléments. Grâce à l'interposition de la galette de fibres optiques entre le faisceau incident et le détecteur, les rayons reçus par chaque élément sont situés à l'intérieur d'un angle solide $\Omega_u$ correspondant à l'angle d'acceptance d'une fibre. Ces p rangées de q éléments fournissent p x q sorties de signal constituant la fonction de détection.

Si une fonction de mutiplexage des p x q sorties de signal sur une sortie unique doit être ajoutée à la fonction de détection, l'ensemble des deux fonctions peut être réalisé sous une forme hybride ou dans une même structure monolithique du détecteur pour les détecteurs infra-rouge de deuxième génération.

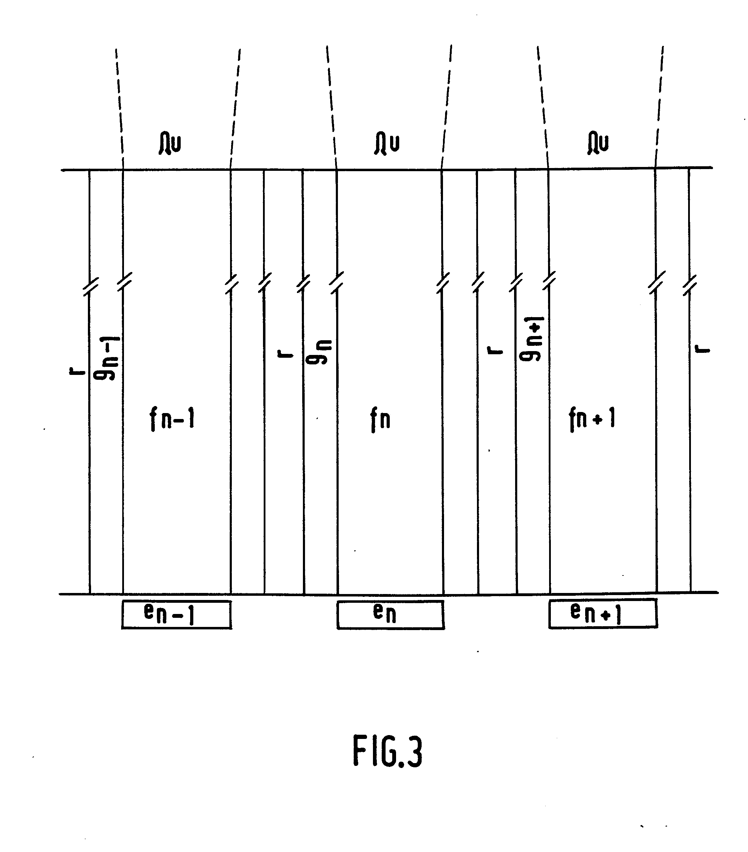

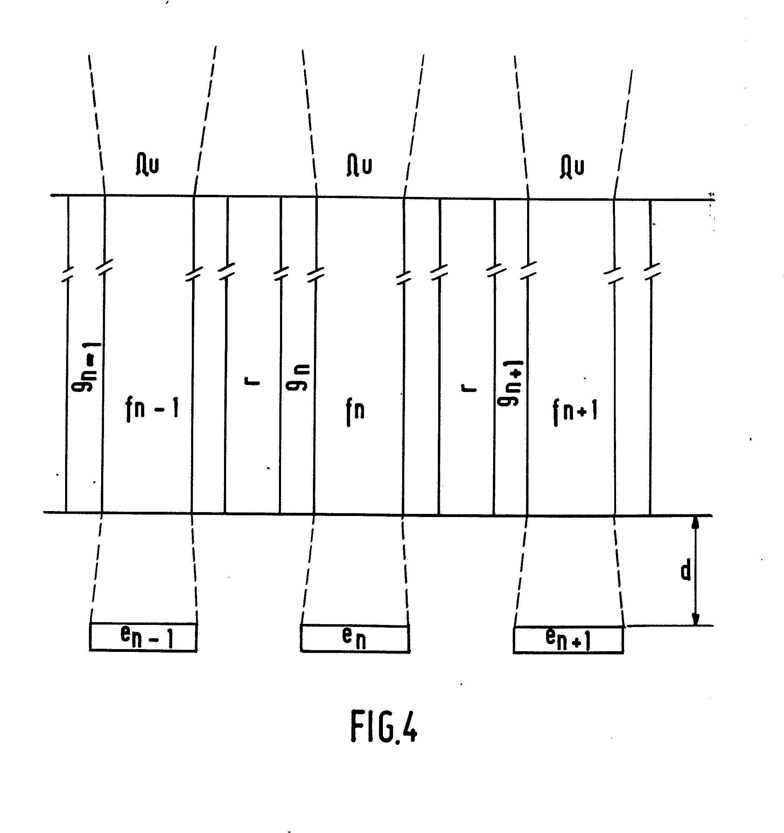

Les figures 3, 4 et 5 donnent des applications possibles d'utilisation de fibres optiques refroidies définissant le champ de vue utile $\Omega_u$ de chaque élément détecteur. Pour fixer les idées, les croquis sont effectués pour les caractéristiques de mosaïques et d'optique mentionnées ci-dessus. On rappelle d'autre part que chaque galette de fibres consiste en l'association de fibres (...$f_{n-1}$, $f_n$, $f_{n+1}$,...) revêtues d'une gaine (...$g_{n-1}$, $g_n$, $g_{n+1}$,...) et liées par un enrobage r type résine ou soudées entre elles ainsi qu'il est représenté sur les figures 3 et 4, chaque fibre comprenant elle-même un verre de coeur et un verre extérieur étant associée à un seul élément détecteur.

Sur la figure 3 les éléments détecteurs ... $e_{n-1}$, $e_n$, $e_{n+1}$... sont plaqués en regard des fibres correspondantes alors que sur la figure 4 ils en sont séparés par la distance d.

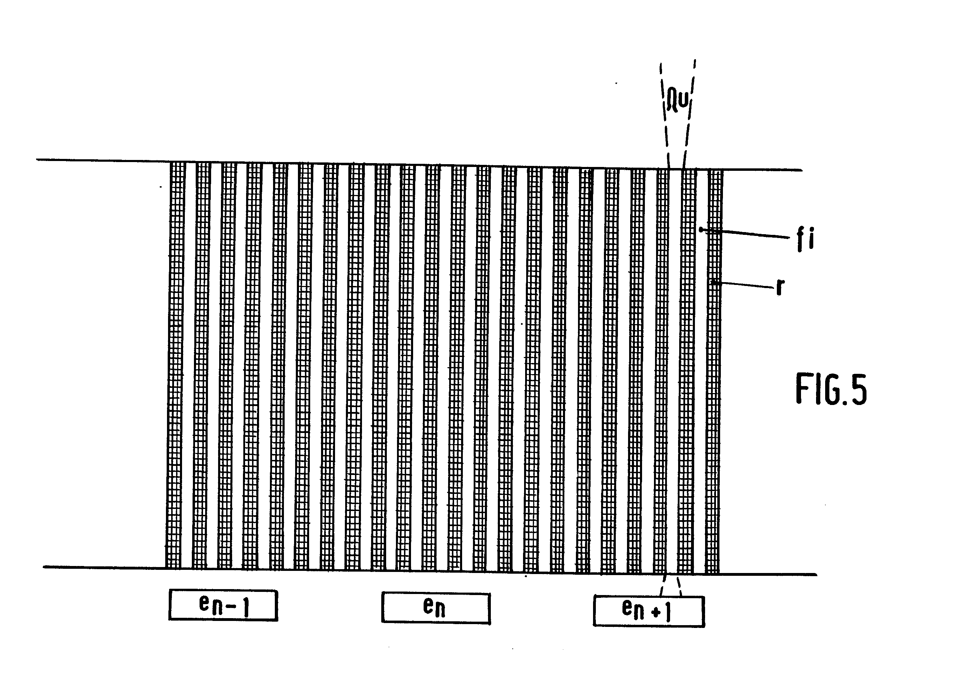

L'association d'une seule fibre à chaque élément sensible du détecteur impose l'obtention d'un bon centrage de la fibre optique sur l'élément sensible. Cette contrainte se trouve éliminée si l'on fabrique des fibres optiques sensibles à l'infrarouge et qui ont un diamètre faible devant les dimensions d'un élément sensible. C'est le cas de la réalisation représentée sur la figure 5 où k fibres

$f_i$ sont associées à chaque élément détecteur. Ces fibres sont de même liées entre elles de façon à constituer une galette convenablement refroidie qui peut être plaquée ou non au détecteur.

**Revendications**

1. Dispositif convertisseur de rayonnement optique en signaux électroniques, comportant une mosaïque de p rangées de q éléments sensibles au rayonnement occupant une grande surface par rapport aux dimensions d'un élément sensible et fournissant p x q sorties de signal, et un faisceau de fibres optiques refroidies, transparentes dans la bande de sensibilité spectrale désirée et qui transmettent auxdits éléments sensibles le rayonnement utile venant d'une scène observée, caractérisé en ce que le faisceau de fibres optiques est constitué par une galette de faible épaisseur solidaire d'un support froid, la mosaïque d'éléments sensibles étant fixée par l'une de ses faces sur ledit support froid à l'intérieur d'une enceinte à faible conductibilité thermique, ladite galette étant en regard d'un hublot transparent dans ladite bande spectrale, l'angle solide uniforme sous lequel chaque élément sensible reçoit du rayonnement étant égal à l'angle d'acceptance d'une fibre.

2. Dispositif selon la revendication 1, caractérisé en ce que ladite enceinte est vide d'air.

3. Dispositif selon la revendication 1, caractérisé en ce que ladite enceinte est remplie d'un gaz à faible conductibilité thermique.

4. Dispositif selon l'une ou l'autre des revendications 1 à 3, caractérisé en ce que chacun desdits éléments détecteurs est associé à plusieurs fibres optiques de ladite galette.

5. Dispositif selon les revendications 1 à 4, caractérisé en ce que chacun desdits éléments détecteurs est associé à une seule fibre optique de ladite galette.

6. Dispositif selon l'une ou l'autre des revendications 1 à 4, caractérisé en ce que chacun desdits éléments détecteurs est associé à plusieurs fibres optiques de ladite galette.

7. Dispositif selon les revendications 1 à 6, caractérisé en ce que la bande de transmission spectrale des fibres est adaptée à l'utilisation de façon à filtrer le signal incident et/ou à augmenter la sensibilité du détecteur par l'usage d'un filtre froid.

FIG.1

FIG.2

FIG.3

FIG.4

FIG.5

0 198 549

5-Ⅴ-PHF 85-523